# EUROPEAN PATENT SPECIFICATION

(11) **EP 1 210 752 B1**
(45) Date of publication and mention of the grant of the patent: **24.11.2004**
(21) Application number: 00975849.1
(22) Date of filing: 01.09.2000
(51) Int. Cl.: H01S 3/16, H01S 5/32

(54) **SEMICONDUCTOR LASER DEVICE FOR ELECTRO-OPTIC APPLICATIONS AND METHOD FOR MANUFACTURING SAID DEVICE**
HALBLEITERLASERVORRICHTUNG FÜR ELEKTRO-OPTISCHE VERWENDUNGEN UND HERSTELLUNGSVERFAHREN
LASER A SEMI-CONDUCTEUR POUR APPLICATIONS ELECTROOPTIQUES ET SON PROCEDE DE FABRICATION

(30) Priority: 02.09.1999 EP 99830544
(43) Date of publication of application: 05.06.2002
(73) Proprietor: STMicroelectronics S.r.l., 20041 Agrate Brianza (Milano) (IT)
(72) Inventor: COFFA, Salvatore, I-95030 Tremestieri Etneo (IT); LIBERTINO, Sebania, I-95127 Catania (IT); SAGGIO, Mario, I-95021 Aci Castello (Catania) (IT); FRISINA, Ferruccio, I-95121 Catania (IT)
(74) Representative: Botti, Mario
(86) International application number: PCT/EP2000/008555
(87) International publication number: WO 2001/017074

(56) References cited:
- EP-A- 0 517 440
- US-A- 5 045 498
- FRANZO G ET AL: "Mechanism and performance of forward and reverse bias electroluminescence at 1.54 mu m from Er-doped Si diodes" JOURNAL OF APPLIED PHYSICS, 15 MARCH 1997, AIP, USA, vol. 81, no. 6, pages 2784-2793, XP002129644 ISSN: 0021-8979
- COFFA S ET AL: "Direct evidence of impact excitation and spatial profiling of excited Er in light emitting Si diodes" APPLIED PHYSICS LETTERS, 6 JULY 1998, AIP, USA, vol. 73, no. 1, pages 93-95, XP002129645 ISSN: 0003-6951 cited in the application
- PATENT ABSTRACTS OF JAPAN vol. 013, no. 295 (E-783), 7 July 1989 (1989-07-07) & JP 01 074783 A (FUJITSU LTD), 20 March 1989 (1989-03-20)

## Description

### Background of the invention

The present invention relates in its more general aspect to a semiconductor laser device for electro-optic applications.

The invention relates also to a method for manufacturing said semiconductor laser device.

More specifically, the invention relates to a semiconductor laser device including at least a rare-earth ions doped P/N junction integrated in a semiconductor substrate.

### Prior Art

As it is well known in this specific technical field, Silicon semiconductor is the material most commonly used for manufacturing advanced microelectronic devices in electronic technology.

The electronic technology may be considered nowadays mature and a new optical communication technology is emerging.

For this kind of optical technology the basic information is carried by optical signals having standard wavelengths comprised in the range between 1.3 and 1.55 microns.

It would be highly desirable to combine optical and electronic functions in silicon to implement opto-electronic applications in a single semiconductor device. A significant progress has recently been made in the combination of electronic and optical technologies for manufacturing semiconductor optical devices operating at near infrared wavelengths.

Few examples are the following :
optical waveguides can be made with low losses, as disclosed by U. Fisher, T. Zinke, J.-R. Kropp, F. Arndt and K. Petermann, in the IEEE article: "Photonics Technology Letters" 8 647 (1996);
light emitting diodes based on Erbium (Er) doping have been demonstrated, as reported by S. Coffa, G. Franzo and F. Priolo, in the MRS Bulletin on "Si-based optoelectronics" 23 n. 4, edited by Materials Research Society, S. Coffa and L. Tsybeskov guest editors;
optical switches based on an electro-optic effect can be realized on Silicon, as disclosed by A. Cutolo, M. Iodice, P. Spirito and L. Zeni, J. of lightwave Technology 15, 505 (1997)

There is however a main limitation for using Silicon in optical applications such as, for example, optical interconnections intra-chip or between chips. This main limitation is due to the lack of a coherent light source, i.e. a Silicon-based laser. Silicon is unsuitable to an efficient light emission due to its indirect band gap.

Several approaches are nowadays used to try to overcome this problem. The use of optical doping of Silicon with rare earth ions, with or without impurities such as O, F, N, presents several interesting features not only for manufacturing efficient light emitting diodes, but also for the attempt of realising a Silicon-based lasers.

Indeed, efficient room temperature electro-luminescence from Erbium-Oxygen co-doped Silicon diodes has been reported. Moreover, the long spontaneous lifetime of the first excited state of erbium (about 1 ms), can certainly guarantee the achievement of a population inversion which is needed for an efficient light emission.

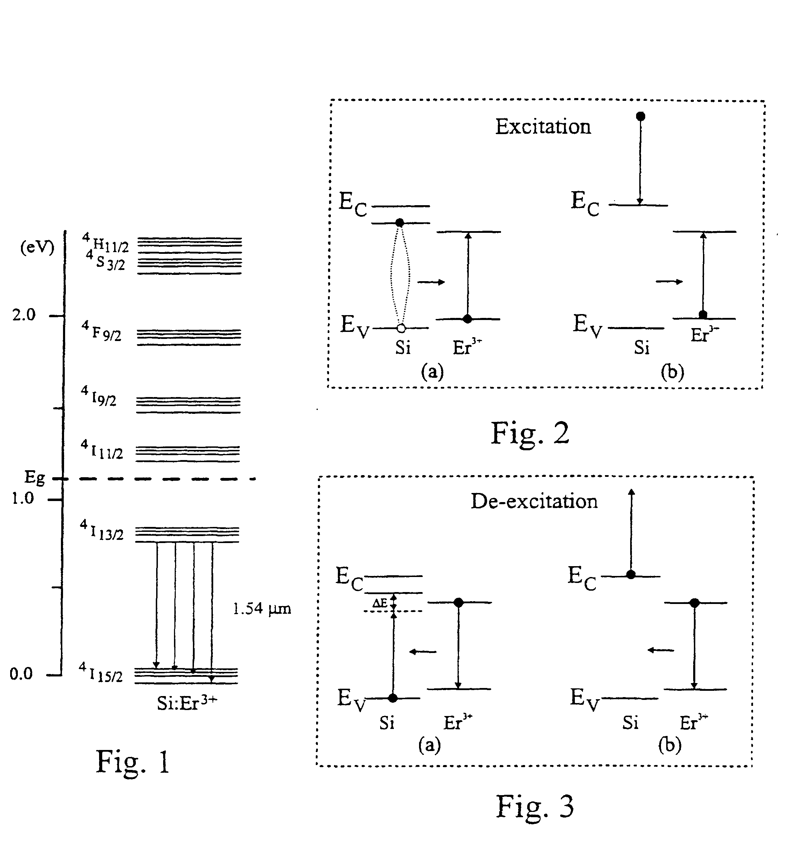

To fully understand all the aspects of the present invention, a schematic diagram of the mechanisms connected to electrical pumping of Erbium ions is shown in Figures 1, 2a, 2b, 3a and 3b.

A room temperature electro-luminescence at 1.54 µm wavelength can be achieved when Er ions are incorporated into a p-n diode junction.

A known solution is disclosed for instance in the US patent No. 5,107,538 that relates to an optical waveguide system comprising a rare-earth Si-based optical device.

This device, however, produces a luminescence only at a temperature close to 4 K and the efficiency of the light emission is extremely reduced at room temperature. Moreover, no teachings may be traced in this documents about the rare-earth ions location inside the junction.

Therefore, the light emission obtained by this technology is insufficient for implementing commercial devices and no electro-optical products on Silicon are known on the market.

The object of the present invention is to provide a new semiconductor device having structural and functional features to allow the implementation of a coherent light emitting source into a semiconductor substrate including a rare-earth ions doped junction.

A further object of the present invention is to provide means for allowing optical interconnections intra-chip or between chips.

A further object of the invention is to provide a single chip integrated semiconductor laser device.

Another object of the present invention is to provide a new semiconductor device having structural and functional features to allow the implementation of a coherent light emitting source in Silicon.

A further object of the invention is to provide a single chip integrated Silicon laser device.

Moreover, the aim of the invention is that of providing an electrically pumped optical amplification and laser action at room temperature.

### Summary of the invention

The solution idea on which the invention is based is that of obtaining an electrically pumped optical amplification, and laser action using Erbium-doped crystalline Silicon. The semiconductor device according to the invention comprises an Erbium-doped p-n junction integrated within a semiconductor cavity or waveguide.

The invention allows to combine impact excitation of Er ions by hot carriers in the depletion layer of the reverse biased junction with a proper Er doping and electric field distribution.

Electro-optical amplification is provided by the embodiment of all the Er ions within the depletion layer of the semiconductor device providing also proper acceleration of the carriers before they enter the Er-doped region.

According to this solution idea the invention relates to a semiconductor laser device defined by the enclosed claim 1.

Moreover, the invention relates to a method for manufacturing a semiconductor laser device as defined in claim 11.

The features and the advantages of the semiconductor device and corresponding manufacturing method according to the invention, will become clear from the following description of a preferred embodiment given as non-limiting example with reference to the attached drawings.

### Brief description of the drawings

Figure 1 shows a schematic diagram of 4f electronic levels of an Erbium ion and the transitions giving rise to a 1.54 µm light emission;
Figures 2a and 2b show the excitation mechanism for rare earth ions in crystalline Silicon, the specific case of Er ions is illustrated;
Figures 3a and 3b show the de-excitation mechanisms for rare earth ions in crystalline Silicon;
Figures from 4 to 8 are schematic cross sectional views of the semiconductor device according to the invention during the subsequent steps of its manufacturing process;
Figure 9 shows a cross-sectional perspective view of a semiconductor device according to the present invention;
Figure 10 shows a schematic view of a vertical cross-section of the semiconductor device of Figure 9 evidencing the location of the rare earth ions needed to achieve laser action according to the present invention;
Figure 11 shows a schematic view of a dark region in the central depletion layer where Er ions are pumped by impact excitation according to the prior art;
Figure 12 shows a diagram of the doping concentration versus doping depth for the semiconductor device of the present invention;
Figure 13 shows a diagram of the electric field versus doping depth for the semiconductor device of the present invention.

### Detailed description

With reference to the enclosed drawings, with 1 is globally and schematically shown a semiconductor device realised according to the present invention for electro-optic applications. The semiconductor material of the present invention is Silicon.

The process for manufacturing the semiconductor device 1 will now be disclosed. The specific features of the inventive semiconductor device 1 will be discussed later for description convenience.

The manufacturing process is described hereinafter step by step.

A SOI (Silicon-On-Insulator) wafer is provided to be used as a substrate 2 for the semiconductor device 1 according to the invention.

A known SIMOX or BESOI technology may be used to provide said SOI wafer.

However, instead of using a SOI wafer, the substrate for the semiconductor device 1 may simply comprise a double layer of a semiconductor material, for instance a first highly doped substrate layer and a second upper lightly doped epitaxial layer. In such a case the lower substrate layer would have a lower refraction index and would act as a reflective layer for the incident light.

The SOI substrate 2 is formed by a first lower monocrystalline layer 3, an oxide layer 4, and a second upper monocrystalline layer 5. The first and the second monocrystalline layers may be doped with a dopant having a first conductivity type, for instance N-type.

The second upper layer 5 is less doped than the first lower layer 3.

An oxide layer 7 is grown on top of the substrate 2, that is over the second upper monocrystalline layer 5.

A photolithographic process step is then provided to define an aperture 8 in said oxide layer 7 and to selectively realise a doped region 10. The dopant used for this region 10 has an opposite conductivity type, for instance P-type.

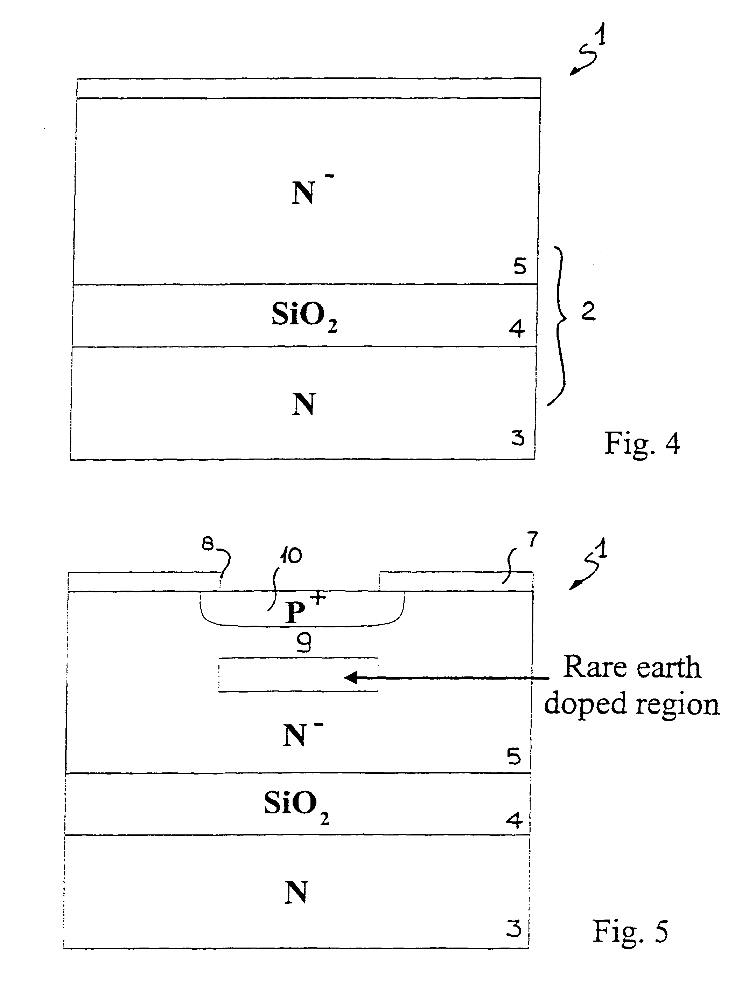

A masked implantation step of B ions in the upper layer 5 allows to realise this p+ doped region 10, as shown in Figure 5.

Through the same mask a rare-earth ions doped region 9 is formed. For example, a ion implantation process step is performed to obtain a region 9 under said p+ doped region 10, as shown in Figure 5. Preferably, said rare earth ions are selected from the group comprising Erbium (Er). A proper co-doping with other impurities, such as O, F, N, may also be used.

Rare earths (RE) incorporation can be achieved using different techniques, such as ion implantation, Molecular Beam Epitaxy (MBE), Chemical Vapor Deposition (CVD), ion assisted deposition, Si-epitaxial regrowth on shallow RE-doped regions. Obviously, different techniques may require different process steps.

The region 9 is an N-type doped region and the stack formed by the regions 5, 9 and 10 form substantially a PN diode junction.

A skilled man may appreciate that the semiconductor device structure of the present invention is similar to a base-collector junction of a bipolar transistor.

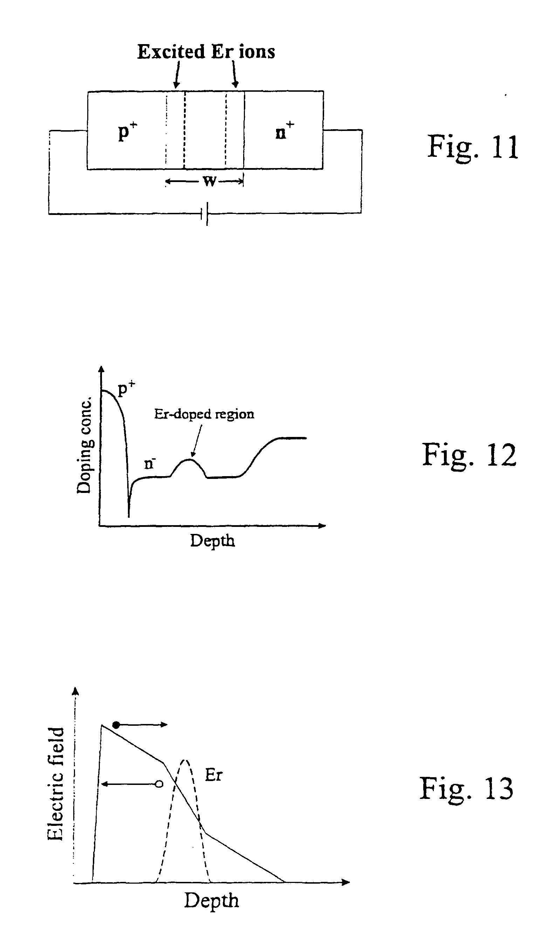

Advantageously, according to the invention, all the implanted Er ions are incorporated in the depletion layer of the PN junction formed by the regions 5, 9 and 10, as clearly shown in Figure 13. Alternatively, all the implanted Er ions are incorporated in the depletion layer of the base collector region of said bipolar transistor.

A masked etching process step is then performed to protect the stacked regions 5, 9 and 10 and to etch the semiconductor at both sides of those regions 9 and 10 to provide a projecting stack region 6 formed just by the p+ doped region 10 and part of the region 5.

A dry or wet etching step may be used for etching the semiconductor.

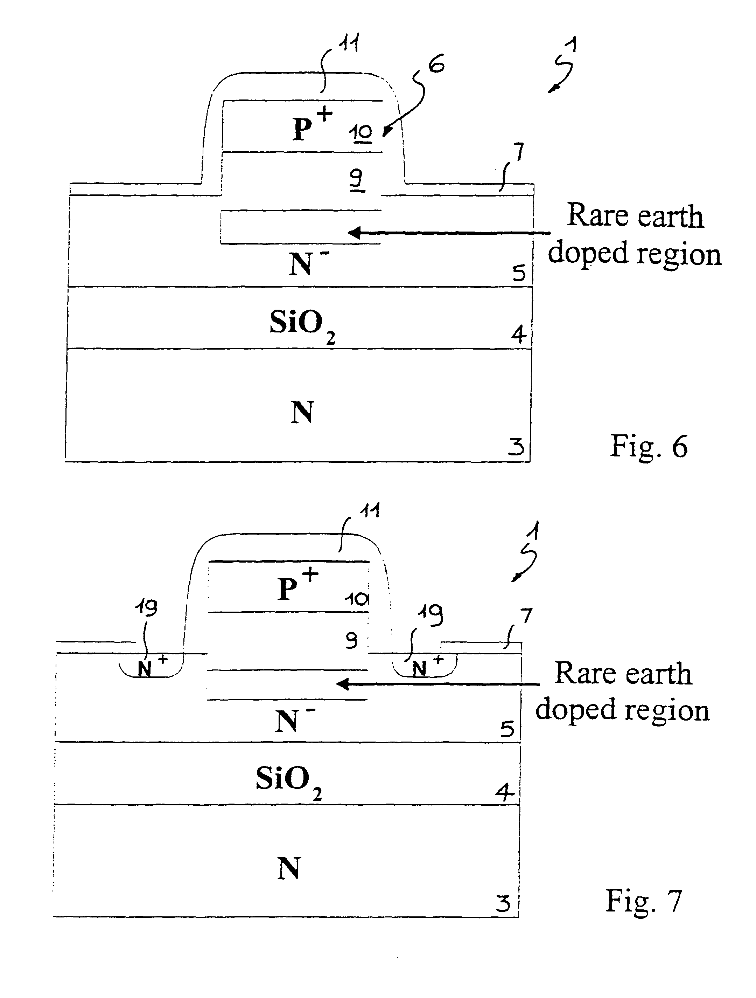

A protective oxide layer 11 is deposited over the resulting stack, as shown in Figure 6.

This protective oxide layer 11 allows to envelope the stack 6 formed by the regions 9 and 10 by a material having a lower dielectric constant.

As a result, a laser cavity or waveguide is obtained on Silicon with the oxide layer 11 delimiting the sides of the waveguide and the buried oxide layer delimiting the bottom of the waveguide.

The device obtained with the inventive method allows to confine light in a two dimensional plane perpendicular to the direction of propagation of the electromagnetic wave. Hence, the semiconductor region containing the gain medium, that is the Erbium ions concentration, is surrounded by a cavity structure or waveguide delimited by a material having a lower refractive index.

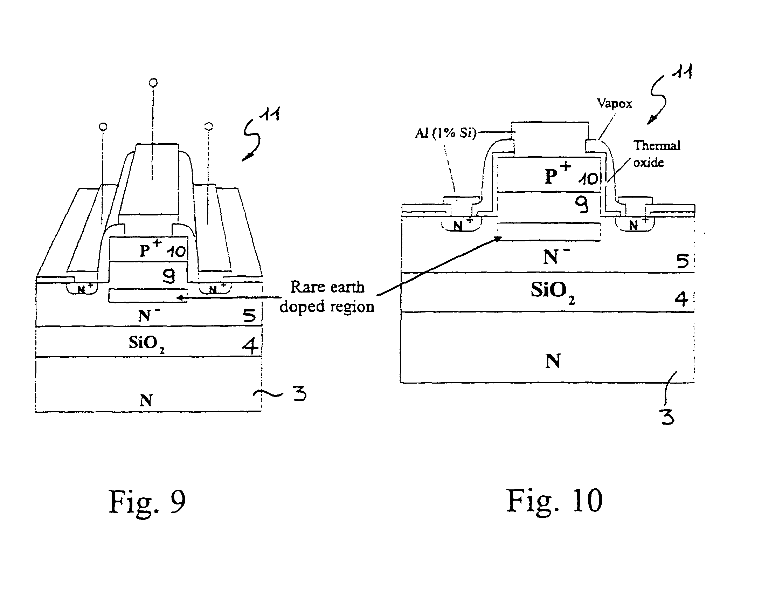

We have disclosed an example to obtain a weveguide having substantially a rib elongated structure as shown in Figure 9. However, other examples may be proposed such as planar waveguides in which the lateral confinement is obtained for instance by shallow trenches filled by a lower refractive index material, or by heavily doped regions as one of the many possible alternatives.

The manufacturing process is carried on by a further masked implantation step of n-type dopants.

Using a suitable mask, not shown, a portion of the protective oxide layer 11 is removed over the upper substrate layer 5, close to the stack 6. N-type dopants, for instance P ions, are implanted in the upper layer 5 thereby forming contact n+ regions 19, as shown in Figure 7.

A further oxide layer is deposited over the whole semiconductor portion and a masked process is used to define contacts openings over the p+ region 10 and over the n+ regions 19.

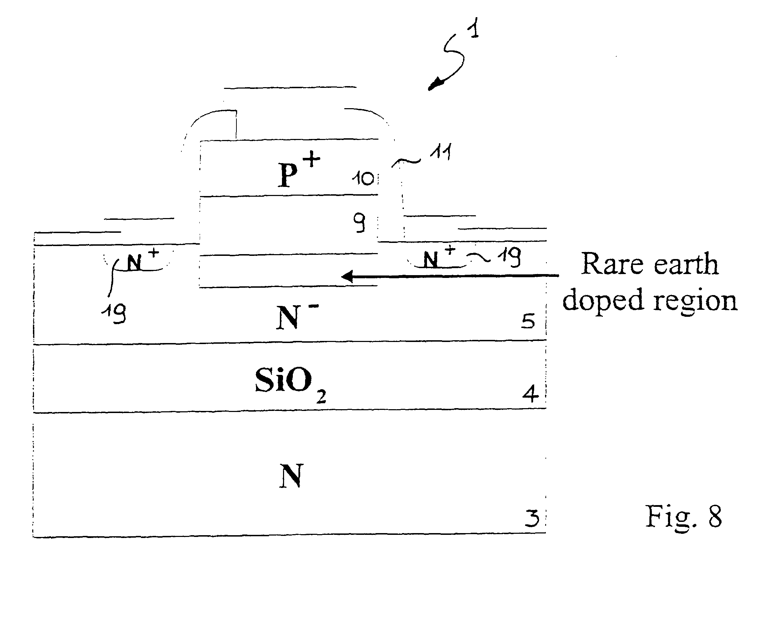

A final deposition step of a metal layer, followed by a lithography step, is performed to define the metal contacts on the p+ and n+ regions 10 and 19 as shown in Figure 8.

The resulting structure is clearly shown in Figure 9 which is a schematic vertical cross-section and perspective view of the semiconductor device 1 including a cavity or waveguide and a p-n diode junction.

Let's now evaluate the specific features of the semiconductor device structure 1 obtained according to the process previously disclosed.

Er ions can be effectively pumped by electron-hole (e-h) recombination, under forward bias diode operation, at temperature below 200 K. However, a phenomenon know as Auger de-excitation and back energy transfer strongly reduces the efficiency of light emission at higher temperatures.

According to the invention, these negative effects are fully inhibited under reverse bias conditions thereby allowing to achieve strong light emission at room temperature.

In fact, all of the implanted Er ions are incorporated in the depletion layer of a p-n junction or, alternatively, in the depletion layer of the base collector region of the bipolar transistor.

Since the characteristic of the invention is the incorporation of the rare earth ions in a depletion layer, electrical pumping of these ions can be achieved in different device structures such as: Schottky diodes, bipolar transistors; MOSFET devices, etc.

Moreover, a sufficient acceleration space is provided before carriers either generated by tunneling in a reverse biased p-n junction or injected by the emitter-base junction of a transistor, enter the Er-doped regions: following this approach population inversion will be extended to all of the Er ions.

After having achieved laser operation at room temperature, an efficient electronic pumping effect can be maintained at room temperature according to the present invention.

Therefore, according to the invention, a proper semiconductor laser device may be realised incorporating the rare-earth ions in a laser cavity which presents low losses at the emission wavelength.

In this respect, the use of a Silicon substrate is certainly an advantage since Silicon semiconductor is almost transparent at the 1.54 µm wavelength. Indeed, integrated Silicon waveguides using Silicon as the core material and Silicon Oxide (SiO2) as claddings have already been manufactured and present losses as low as 0.1 dB/cm.

According to the invention, rare-earth ions doping of these waveguides, within an integrated devices structure allowing electrical pumping of the rare earth ions, can be used to produce the laser cavity.

Diode operation at the diode breakdown threshold results in an intense light emission at 1.54 µm, characterised by an internal quantum efficiency of about 0.1 %.

It may be demonstrated that in such a structure the Er ions are pumped to the excited levels as a result of impact excitation by hot carriers.

Impact excitation with hot carriers is provided to invert Er population rather than electron-hole recombination.

During pumping, since the Er ions are embodied in the depletion layer of a junction, the losses due to the free electrons will be fully inhibited and the laser action would benefit of the extremely low losses that intrinsic Silicon exhibit at 1.54 µm.

This amplification gain at 1.54 µm can overcome waveguide losses and laser action can be achieved if a proper cavity reflectors structure can be realised, as the inventive method has demonstrated.

In order to remark how to obtain a proper laser action reference is still made to the schematic view of Figure 9. The semiconductor device 1 is realised using a silicon on insulators (SOI) substrate 2 and the process previously disclosed. The stacked p-n junction 6 is doped with rare earth ions. Er pumping will result in light emission coupled to the fundamental modes of the cavity. This structure could be used both as an electrically pumped optical amplifier or as a laser, if proper feedback can be achieved. Cleaved output and input waveguide facets, or distributed Bragg reflector structures, can be suitably used to provide the feedback needed for laser action.

The most important limitation that the invention has overcome was due to an insufficient Er concentration in order to achieve a laser action at 1.54 µm in the Er-doped Silicon substrate using an integrated waveguide.

Since Erbium in Silicon acts as a donor, a high concentration of free electrons in the region where Erbium sits is present. It should be noted that, in order to incorporate high Er concentration in Silicon semiconductor, co-doping with impurities such as O and F plays a fundamental role. However this co-doping also produces a strong donor activity of the Er ions resulting in a high concentration of free electrons in the region where Er sits.

When Erbium is incorporated within a structure, such as the channel waveguide previously disclosed, the strong concentration of free electrons will produce, by the plasma dispersion effect, strong losses which would make impossible the achievement of a net gain. Indeed, free carrier concentration has to be maintained below 10¹⁷/cm³ to achieve low losses.

In fact, due to the donor behavior of Er, both the real and the imaginary part of the refractive index are strongly affected by the high free carrier concentration, and the mode tends to escape from the region where Er sits. Moreover, effective loss as high as ∼ 200 cm⁻¹ can be obtained.

A problem to be solved results from the use of impact excitation of Er ions in reverse biased p-n junctions because of the existence of a "dark region" in the central portion of the depletion layer where carriers have not enough energy to pump Er ions.

It has been experimentally demonstrated by S. Coffa, G. Franzò, F. Priolo, A. Pacelli, A. Lacaita, Appl. Phys. Lett. 73, 93 (1998) that a region of about 400 A in the central portion of about 1000 Å thick depletion layer, is dark.

Such a behavior is schematically shown in Figure 11. In fact, the peculiar feature of impact excitation is due to the existence of a threshold. If the energy of the carrier is lower than that required to promote the Er ions to the first excited state (0.8 eV) the process cannot occur.

A second problem is that the Er ions sitting outside the depletion layer cannot be pumped by this mechanism, hence will not be excited, but will adsorb light at 1.54 µm.

The Er population cannot hence be inverted in the central part of the diode since there the energy of the carriers, produced by band to band tunneling and then accelerated by the strong electric field present at the junction, is not sufficient to pump Er.

An effective pumping of Er ions in order to achieve population inversion and the capability of maintaining low losses in the Er doped waveguides is achieved by the inventive structure. How the invention solves these two problems is examined in details hereinafter.

The inventive device and method solve all the previously remarked problems by incorporating all the implanted Er ions in the depletion layer of the p-n junction and providing:
1. a sufficient acceleration space before carriers enter the Er-doped regions.
2. population inversion extended to all the Er ions.
3. Inhibition of loss due to free electrons just because the Erbium ions are embodied in the junction depletion layer. The laser action would benefit of the extremely low loss that intrinsic Si exhibits at 1.54 µm. Er has been placed where the maximum of the mode sits.

Since the Erbium ions sit in the depletion region, the free carrier concentration strongly decreases and effective loss as low as 0.6 cm⁻¹ has been evaluated.

## Claims

1. Semiconductor laser device for electro-optic applications of the type including at least a doped P/N junction (5, 10) integrated in a semiconductor substrate (2) and including a rare-earth ions doped region (9), said P/ N junction (5, 10) being provided within a cavity or a waveguide structure to form a coherent light source, **characterised in that** said rare-earth ions region (9) is realised in the depletion layer of said P/N junction and that a biasing device is provided to reverse bias said P/N junction and obtain said coherent light source in said semiconductor substrate (2) by pumping the rare-earth ions of said region (9) at room temperature, a sufficient acceleration space being provided before carriers enter said rare-earth ions region (9).

2. Semiconductor laser device according to claim 1, wherein said rare-earth ions region (9) realised within said doped P/N junction (5, 10) is the base-collector region of a bipolar transistor.

3. Semiconductor laser device according to claim 1, wherein said rare-earth ions are Erbium ions.

4. Semiconductor laser device according to claim 1, wherein said cavity or waveguide structure includes said P/N junction (5, 10) and is partially enveloped by a protective layer (11) having a lower dielectric constant with respect to said P/N junction (5, 10).

5. Semiconductor laser device according to claim 1, wherein a buried reflecting layer is provided to delimit the bottom of said waveguide structure.

6. Semiconductor laser device according to claim 1, wherein said semiconductor substrate (2) is a SOI substrate.

7. Semiconductor laser device according to claim 1, wherein said semiconductor substrate (2) is an epitaxial layer covering an heavily doped substrate layer.

8. Semiconductor laser device according to claim 1, wherein said cavity or waveguide structure has a rib elongated structure projecting from the semiconductor (2) surface.

9. Semiconductor laser device according to claim 1, wherein said semiconductor is Silicon.

10. Semiconductor laser device according to claim 1, wherein said biasing device is a bipolar transistor and said P/N junction (5, 10) is the base-collector region of said bipolar transistor.

11. A method for manufacturing a semiconductor laser device (1) for electro-optic applications, said laser device (1) including at least a doped P/N junction (5, 10) integrated in a semiconductor substrate (2) and including a rare-earth ions region (9), a cavity or waveguide structure being provided around said P/N junction (5, 10), **characterised in that** said rare-earth ions region (9) is realised in the depletion layer of said P/N junction (5, 10) and that a biasing device is provided to reverse bias said P/N junction (5, 10) and obtain a coherent light source in said semiconductor substrate (2) by pumping the rare-earth ions of said region (9) at room temperature, a sufficient acceleration space being provided before carriers enter said rare-earth ions region (9).

12. Method according to claim 11, wherein said biasing device is a bipolar transistor and said rare-earth ions doped P/N junction (5, 10) forms the base-collector region of said bipolar transistor.

13. Method according to claim 11, wherein said rare-earth ions are Erbium ions.

14. Method according to claim 11, wherein said cavity or waveguide structure includes said P/N junction (5, 10) and is partially enveloped by a protective layer (11) having a lower dielectric constant with respect to said P/N junction (5, 10).

15. Method according to claim 11, wherein a buried reflecting layer is provided to delimit the bottom of said waveguide structure.

16. Method according to claim 11, wherein said semiconductor substrate (2) is a SOI substrate.

17. Method according to claim 11, wherein said semiconductor substrate (2) is an epitaxial layer covering an heavily doped substrate layer.

18. Method according to claim 11, wherein said cavity or waveguide structure has a rib elongated structure projecting from the semiconductor surface.

19. Method according to claim 1, wherein said semiconductor is Silicon.

## Patentansprüche

1. Halbleiter-Laser-Vorrichtung für elektro-optische Anwendungen in einer Ausführung, die mindestens einen dotierten PN-Übergang (5, 10) enthält, der in ein Halbleitersubstrat (2) integriert ist und eine mit Seltene-Erden-Ionen dotierte Zone (9) enthält, wobei besagter PN-Übergang (5, 10) in einer Resonator- oder einer Wellenleiterstruktur vorgesehen ist, um eine kohärente Lichtquelle zu bilden, **dadurch gekennzeichnet, dass** besagte Seltene-Erden-Ionen-Zone (9) in der Verarmungsschicht von besagtem PN-Übergang verwirklicht ist und dass eine Vorspannvorrichtung vorgesehen ist, um besagten PN-Übergang in Sperrrichtung vorzuspannen und besagte kohärente Lichtquelle in besagtem Halbleitersubstrat (2) zu erhalten, indem die Seltene-Erden-Ionen besagter Zone (9) bei Raumtemperatur gepumpt werden, wobei ein ausreichender Beschleunigungsraum geschaffen wird, bevor die Ladungsträger in besagte Seltene-Erden-Ionen-Zone (9) eintreten.

2. Halbleiter-Laser-Vorrichtung nach Anspruch 1, wobei besagte Seltene-Erden-Ionen-Zone (9), die in besagtem PN-Übergang (5, 10) verwirklicht ist, der Basis-Kollektor-Bereich von einem bipolaren Transistor ist.

3. Halbleiter-Laser-Vorrichtung nach Anspruch 1, wobei besagte Seltene-Erden-Ionen Erbium-Ionen sind.

4. Halbleiter-Laser-Vorrichtung nach Anspruch 1, wobei besagte Resonator- oder Wellenleiterstruktur besagten PN-Übergang (5, 10) enthält und teilweise in eine Schutzschicht (11) eingehüllt ist, die im Verhältnis zu besagtem PN-Übergang (5, 10) eine niedrigere dielektrische Konstante hat.

5. Halbleiter-Laser-Vorrichtung nach Anspruch 1, wobei eine vergrabene reflektierende Schicht vorgesehen ist, um den Boden besagter Wellenleiterstruktur zu begrenzen.

6. Halbleiter-Laser-Vorrichtung nach Anspruch 1, wobei besagtes Halbleitersubstrat (2) ein SOI(Silicon-On-Insulator; Silizium auf Isolator)-Substrat ist.

7. Halbleiter-Laser-Vorrichtung nach Anspruch 1, wobei besagtes Halbleitersubstrat (2) eine epitaktische Schicht ist, die eine stark dotierte Substratschicht bedeckt.

8. Halbleiter-Laser-Vorrichtung nach Anspruch 1, wobei besagte Resonator- oder Wellenleiterstruktur eine rippenförmig längliche Struktur hat, die aus der Oberfläche des Halbleiters (2) herausragt.

9. Halbleiter-Laser-Vorrichtung nach Anspruch 1, wobei besagter Halbleiter Silizium ist.

10. Halbleiter-Laser-Vorrichtung nach Anspruch 1, wobei besagte Vorspannvorrichtung ein bipolarer Transistor ist und besagter PN-Übergang (5, 10) der Basis-Kollektor-Bereich von besagtem bipolaren Transistor ist.

11. Methode zur Herstellung einer Halbleiter-Laser-Vorrichtung (1) für elektro-optische Anwendungen, wobei besagte Laser-Vorrichtung (1) mindestens einen dotierten PN-Übergang (5, 10) enthält, der in ein Halbleitersubstrat (2) integriert ist und eine Seltene-Erden-Ionen-Zone (9) enthält, wobei um besagten PN-Übergang (5, 10) eine Resonator- oder Wellenleiterstruktur geschaffen wird, **dadurch gekennzeichnet, dass** besagte Seltene-Erden-Ionen-Zone (9) in der Verarmungsschicht von besagtem PN-Übergang (5, 10) verwirklicht wird und dass eine Vorspannvorrichtung geschaffen wird, um besagten PN-Übergang (5, 10) in Sperrichtung vorzuspannen und eine kohärente Lichtquelle in besagtem Halbleitersubstrat (2) zu erhalten, indem die Seltene-Erden-Ionen besagter Zone (9) bei Raumtemperatur gepumpt werden, wobei ein ausreichender Beschleunigungsraum geschaffen wird, bevor die Ladungsträger in besagte Seltene-Erden-Ionen-Zone (9) eintreten.

12. Verfahren nach Anspruch 11, wobei besagte Vorspannvorrichtung ein bipolarer Transistor ist und besagter mit Seltene-Erden-Ionen dotierter PN-Übergang (5, 10) den Basis-Kollektor-Bereich von besagtem bipolaren Transistor bildet.

13. Verfahren nach Anspruch 11, wobei besagte Seltene-Erden-Ionen Erbiumlonen sind.

14. Verfahren nach Anspruch 11, wobei besagte Resonator- oder Wellenleiterstruktur besagten PN-Übergang (5, 10) enthält und teilweise in eine Schutzschicht (11) eingehüllt ist, die im Verhältnis zu besagtem PN-Übergang (5, 10) eine niedrigere dielektrische Konstante hat.

15. Verfahren nach Anspruch 11, wobei eine vergrabene reflektierende Schicht geschaffen wird, um den Boden von besagter Wellenleiterstruktur zu begrenzen.

16. Verfahren nach Anspruch 11, wobei besagtes Halbleitersubstrat (2) ein SOI-Substrat ist.

17. Verfahren nach Anspruch 11, wobei besagtes Halbleitersubstrat (2) eine epitaktische Schicht ist, die eine stark dotierte Substratschicht bedeckt.

18. Verfahren nach Anspruch 11, wobei besagte Resonator- oder Wellenleiterstruktur eine rippenförmig längliche Struktur hat, die aus der Oberfläche des Halbleiters herausragt.

19. Verfahren nach Anspruch 11, wobei besagter Halbleiter Silizium ist.

## Revendications

1. Dispositif laser à semi-conducteur pour applications électro-optiques du type incluant au moins une jonction PN dopée (5, 10) intégrée dans un substrat semi-conducteur (2) et incluant une région dopée à ions de terres rares (9), ladite jonction PN (5, 10) étant prévue à l'intérieur d'une cavité ou d'une structure en guide d'ondes pour former une source de lumière cohérente, **caractérisé en ce que** ladite région à ions de terres rares (9) est réalisée dans la zone de déplétion de ladite jonction PN et **en ce qu'**un dispositif de polarisation est fourni pour polariser dans le sens inverse ladite jonction PN et obtenir ladite source de lumière cohérente dans ledit substrat semi-conducteur (2) en pompant les ions de terres rares de ladite région (9) à température ambiante, un espace d'accélération suffisant étant prévu avant que des porteurs de charge ne pénètrent dans ladite région à ions de terres rares (9).

2. Dispositif laser à semi-conducteur selon la revendication 1, dans lequel ladite région à ions de terres rares (9) réalisée à l'intérieur de ladite jonction PN dopée (5, 10) est la région base-collecteur d'un transistor bipolaire.

3. Dispositif laser à semi-conducteur selon la revendication 1, dans lequel lesdits ions de terres rares sont des ions Erbium.

4. Dispositif laser à semi-conducteur selon la revendication 1, dans lequel ladite cavité ou structure en guide d'ondes inclut ladite jonction PN (5, 10) et est partiellement enveloppée par une couche de protection (11) ayant une constante diélectrique inférieure par rapport à ladite jonction PN (5, 10).

5. Dispositif laser à semi-conducteur selon la revendication 1, dans lequel une couche réfléchissante enterrée est fournie pour délimiter la partie inférieure de ladite structure en guide d'ondes.

6. Dispositif laser à semi-conducteur selon la revendication 1, dans lequel ledit substrat semi-conducteur (2) est un substrat SOI.

7. Dispositif laser à semi-conducteur selon la revendication 1, dans lequel ledit substrat semi-conducteur (2) est une couche épitaxiale recouvrant une couche de substrat fortement dopée.

8. Dispositif laser à semi-conducteur selon la revendication 1, dans lequel ladite cavité ou structure en guide d'ondes a une structure allongée nervurée faisant saillie de la surface du semi-conducteur (2).

9. Dispositif laser à semi-conducteur selon la revendication 1, dans lequel ledit semi-conducteur est du Silicium.

10. Dispositif laser à semi-conducteur selon la revendication 1, dans lequel ledit dispositif de polarisation est un transistor bipolaire et ladite jonction PN (5, 10) est la région base-collecteur dudit transistor bipolaire.

11. Procédé de fabrication d'un dispositif laser à semi-conducteur (1) pour applications électro-optiques, ledit dispositif laser (1) incluant au moins une jonction PN dopée (5, 10) intégrée dans un substrat semi-conducteur (2) et incluant une région à ions de terres rares (9), une cavité ou structure en guide d'ondes étant fournie autour de ladite jonction PN (5, 10), **caractérisé en ce que** ladite région à ions de terres rares (9) est réalisée dans la zone de déplétion de ladite jonction PN (5, 10) et **en ce qu'**un dispositif de polarisation est fourni pour polariser dans le sens inverse ladite jonction PN (5, 10) et obtenir une source de lumière cohérente dans ledit substrat semi-conducteur (2) en pompant les ions de terres rares de ladite région (9) à température ambiante, un espace d'accélération suffisant étant prévu avant que des porteurs de charge ne pénètrent dans ladite région à ions de terres rares (9).

12. Procédé selon la revendication 11, dans lequel ledit dispositif de polarisation est un transistor bipolaire et ladite jonction PN dopée à ions de terres rares (5, 10) forme la région base-collecteur dudit transistor bipolaire.

13. Procédé selon la revendication 11, dans lequel lesdits ions de terres rares sont des ions Erbium.

14. Procédé selon la revendication 11, dans lequel ladite cavité ou structure en guide d'ondes inclut ladite jonction PN (5, 10) et est partiellement enveloppée par une couche de protection (11) ayant une constante diélectrique inférieure par rapport à ladite jonction PN (5, 10).

15. Procédé selon la revendication 11, dans lequel une couche réfléchissante enterrée est fournie pour délimiter la partie inférieure de ladite structure en guide d'ondes.

16. Procédé selon la revendication 11, dans lequel ledit substrat semi-conducteur (2) est un substrat SOI.

17. Procédé selon la revendication 11, dans lequel ledit substrat semi-conducteur (2) est une couche épitaxiale recouvrant une couche de substrat fortement dopée.

18. Procédé selon la revendication 11, dans lequel ladite cavité ou structure en guide d'ondes a une structure allongée nervurée faisant saillie de la surface du semi-conducteur.

19. Procédé selon la revendication 11, dans lequel ledit semi-conducteur est du Silicium.
